**Europäisches Patentamt**

(19) **European Patent Office**

**Office européen des brevets**

(11) Numéro de publication: **0 002 550**
**B1**

(12) FASCICULE DE BREVET EUROPEEN

(45) Date de publication du fascicule de brevet:
**28.01.81**

(21) Numéro de dépôt: **78200340.4**

(22) Date de dépôt: **04.12.78**

(51) Int. Cl.³: **H 01 L 21/283**, H 01 L 31/02

(54) **Procédé de création, par sérigraphie, d'un contact à la surface d'un corps semiconducteur et dispositif obtenu par ce procédé.**

(30) Priorité: **13.12.77 FR 7737517**

(43) Date de publication de la demande:
**27.06.79 Bulletin 79/13**

(45) Mention de la délivrance du brevet:
**28.01.81 Bulletin 81/4**

(84) Etats contractants désignés:
**DE FR GB**

(56) Documents cités:
**FR-A-1 154 322**
**FR-A-2 081 909**
**GB-A-1 286 373**

(73) Titulaire: **R.T.C. LA RADIOTECHNIQUE-COMPELEC Société anonyme dite:, 51 rue Carnot, F-92156 Suresnes (FR)**

(84) Etats contractants désignés: **FR**

(73) Titulaire: **N.V. Philips' Gloeilampenfabrieken, Pieter Zeemanstraat 6, NL-5621 CT Eindhoven (NL)**

(84) Etats contractants désignés: **DE GB**

(72) Inventeur: **Diguet, Daniel, S.P.I.D. 209, rue de l'Université, F-75007 Paris (FR)**
Inventeur: **David, Gérard André, S.P.I.D. 209, rue de l'Université, D-75007 Paris (FR)**
Inventeur: **Aubril, Pierre, S.P.I.D. 209, rue de l'Université, F-75007 Paris (FR)**

(74) Mandataire: **Labaloue, André et al, 209, rue de l'Université, F-75007 Paris (FR)**

ACTORUM AG.

**Procédé de création, par sérigraphie, d'un contact à la surface d'un corps semiconducteur et dispositif obtenu par ce procédé**

La présente invention concerne un procédé de création, sur une aire d'une surface d'un corps semiconducteur, d'une configuration de contact apte au soudage d'une connexion métallique, ledit corps comportant une région, d'un type de conductivité déterminé, affleurant ladite surface suivant ladite aire, procédé consistant principalement à appliquer par sérigraphie, au moins sur une partie de ladite aire, une pâte conductrice contenant notamment dans une phase vitrifiable, au moins un métal principal finement divisé et un élément de dopage donnant ledit même type de conductivité, puis, ultérieurement, à vitrifier thermiquement ladite pâte dans des conditions telles que ledit dopant migre au moins dans une partie superficielle de ladite région.

La présente invention concerne également la prise de contact sur la face postérieure des cellules solaires à semiconducteur et les cellules obtenues selon ce procédé.

On sait qu'actuellement des études intensives sont menées, dans de nombreux laboratoires, pour trouver les moyens d'abaisser le prix de revient des générateurs solaires photovoltaïques. Outre le prix encore élevé du matériau semiconducteur lui-même, certaines étapes de la fabrication des cellules solaires font obstacle à l'abaissement du prix de revient, si on conserve les procédés actuellement en usage. Il en est ainsi particulièrement pour ce qui est de l'opération de prise de contact sur chaque face des cellules faisant appel au dépôt par évaporation sous vide, selon les techniques éprouvées et mises au point depuis l'avènement des applications spatiales de l'énergie solaire.

Le remplacement, toutes les fois que cela est possible, de ladite technique d'évaporation, jugée trop onéreuse, par une technique plus aisée à automatiser et avec des matériels moins coûteux, est considéré par les spécialistes comme une mesure de valeur industrielle et économique certaine. Il est connu que l'utilisation de pâtes conductrices appliquées par sérigraphie sur les cellules solaires pourrait constituer une solution au problème évoqué, notamment au point de vue de l'économie recherchée. Par exemple, l'article de M.B. Field et L.R. Scudder paru à la suite de la 12ème Conférence des Spécialistes de l'énergie photovoltaïque tenue à Bâton Rouge – EUA – IEEE Proceedings 1976, p. 303, fait état de travaux effectués dans ce sens. Cependant, le procédé qui consiste à créer un contact sur une aire de la surface d'un corps semiconducteur, par exemple sur la face postérieure d'une cellule solaire (c'est-à-dire la face opposée à la face photosensible) en utilisant la technique de sérigraphie comporte de nombreuses difficultés parmi lesquelles il faut citer: la difficulté de soudage ultérieur à une languette de connexion lorsqu'un pourcentage élevé de l'élément de dopage est introduit dans la pâte conductrice, ou bien encore l'absence d'ohmicité du contact avec résistance élevée de contact lorsque, au contraire, c'est un pourcentage relativement faible dudit élément de dopage qui est incorporé à ladite pâte.

Une autre difficulté est constituée par le fait, observé par la Demanderesse, que la présence de l'élément de dopage dans le dépôt vitrifié du contact interfère avec ses propriétés physico-chimiques d'une manière défavorable. En effet, la tenue mécanique d'une connexion soudée audit dépôt vitrifié se dégrade de manière inacceptable lorsque le dispositif est soumis à des contraintes d'environnement sévère. Or, la longévité des générateurs d'énergie solaire représente un facteur qui leur est indispensable et revêt de ce fait une grande importance.

L'invention a pour but, entre autres, de remédier à ces inconvénients, de manière à rendre utilisable la technique de la sérigraphie pour la prise de contact à la surface d'un dispositif semiconducteur et particulièrement sur une cellule solaire.

La présente invention prend en considération le fait que la configuration de contact créée sur la surface d'un corps semiconducteur avait plusieurs fonctions qui pouvaient être dissociées entre elles.

Suivant l'invention, un procédé de création, sur une aire d'une surface d'un corps semiconducteur, d'une configuration de contact apte au soudage d'une connexion métallique, ledit corps comportant une région, d'un type de conductivité déterminé, affleurant ladite surface suivant ladite aire, procédé consistant principalement à appliquer par sérigraphie, au moins sur une partie de ladite aire, une pâte conductrice contenant notamment, dans une phase vitrifiable, au moins un métal principal finement divisé et un élément de dopage donnant ledit même type de conductivité, puis, ultérieurement, à vitrifier thermiquement ladite pâte dans des conditions telles que ledit dopant migre au moins dans une partie superficielle de ladite région, est notamment remarquable en ce que, après avoir, dans un premier dépôt, appliqué ladite pâte conductrice contenant ledit élément de dopage et après avoir au moins partiellement séché ledit premier dépôt, on effectue, face à au moins une plage restreinte de ladite aire qui contient l'emplacement destiné au soudage de ladite connexion, un second dépôt avec une pâte conductrice contenant notamment, dans une phase vitrifiable, au moins un métal principal et essentiellement dépourvue dudit élément de dopage, au moins une partie du second dépôt reposant sur une partie du premier dépôt, l'ensemble des deux dépôts constituant ladite configuration de contact, et en ce qu'on effectue ensuite le traitement de vitrification.

Le procédé selon l'invention a l'avantage de permettre l'obtention d'une configuration de contact qui présente à la fois d'excellentes caractéristiques électriques, une très bonne tenue mécanique sous l'effet d'une contrainte climatique sévère et enfin une parfaite soudabilité dans les conditions opératoires habituelles.

Avantageusement, dans le procédé selon l'invention, la plage en face de laquelle est localisé ledit second dépôt représente une superficie inférieure à 20% de ladite aire et, de préférence, inférieure à 5% seulement de ladite aire. Ainsi, le dispositif manifeste alors des caractéristiques électriques qui sont très comparables à celles des dispositifs obtenus selon la technologie classique, plus onéreuse.

Dans un premier mode de mise en œuvre de l'invention ledit premier dépôt est appliqué sur l'essentiel de ladite aire et ledit second dépôt est établi par-dessus ledit premier dépôt.

Dans un deuxième mode de mise en œuvre de l'invention, ledit premier dépôt étant appliqué sur ladite aire, on y aménage au moins un évidement sur ledit emplacement de soudage. Ledit second dépôt, qui s'étend sur une partie du premier dépôt, est alors conformé de manière à s'étendre aussi sur la surface du corps, dans ledit évidement.

Le premier mode de mise en œuvre est avantageux par sa simplicité. Il permet d'abaisser localement la concentration moyenne de l'élément de dopage à l'emplacement destiné au soudage de la connexion par raport au reste de la configuration, ce qui améliore à la fois la soudabilité en cet emplacement et la résistance mécanique de la soudure au vieillissement; partout ailleurs, le premier dépôt assure un bon contact électrique avec le matériau semiconducteur.

Le deuxième mode de mise en œuvre de l'invention a l'avantage, au prix d'un alignement des deux dépôts l'un sur l'autre, d'annuler la concentration en élément de dopage dans la partie de la configuration de contact qui est prévue pour le soudage de la connexion. La qualité de la soudure est alors optimale indépendamment de la concentration en élément de dopage dans le premier dépôt.

Avantageusement, ledit second dépôt est réalisé avec une épaisseur sensiblement supérieure à celle dudit premier dépôt ce qui renforce encore la longévité de la soudure de la connexion sous contrainte sévère d'environnement.

Avantageusement, le traitement de vitrification des premier et second dépôts est effectué simultanément à une température comprise entre 600 et 750°C.

L'invention concerne également un dispositif, notamment pour la conversion photovoltaïque du rayonnement solaire, issu du procédé décrit, remarquable en ce que la région dudit corps sur laquelle est faite la prise de contact, est en silicium de type p, le métal principal est l'argent (ou encore le cuivre) et ledit élément de dopage est l'aluminium (ou encore le gallium ou le palladium).

La description qui va suivre en regard des dessins annexés fera bien comprendre comment l'invention peut être réalisée au moyen d'exemples non limitatifs.

La fig. 1 montre en coupe schématique une configuration de contact créée à la surface d'un corps semiconducteur par le procédé selon l'invention, suivant une première forme de mise en œuvre.

La fig. 2 montre en coupe schématique une configuration de contact créée par le procédé selon l'invention, dans une deuxième forme de mise en œuvre.

La fig. 3 représente en plan l'application du procédé selon l'invention à la prise du contact sur la face postérieure d'une cellule solaire.

Il est à noter que, dans les figures, les proportions, notamment d'épaisseur, ne sont pas respectées de manière à rendre les dessins plus clairs.

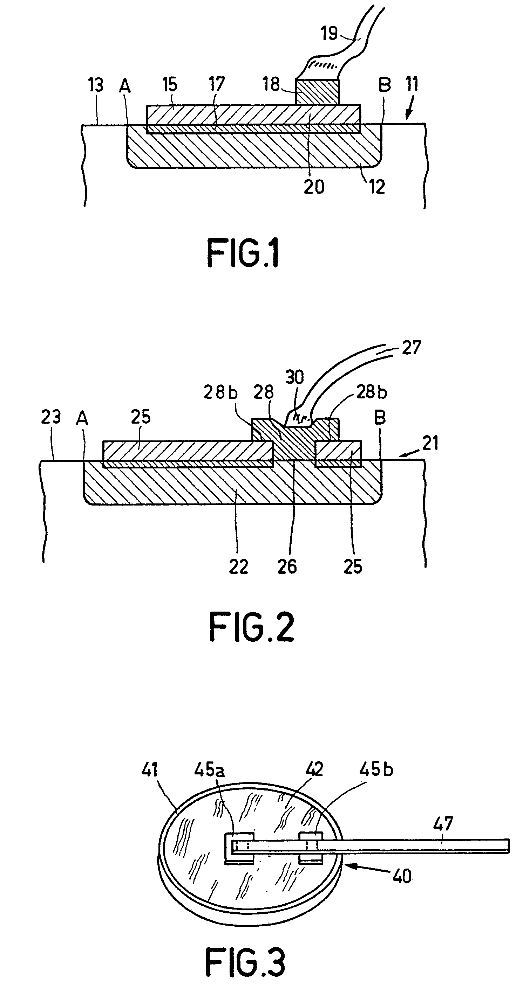

La fig. 1 montre une partie d'un corps semiconducteur 11, comportant une région 12 de type p par exemple. La région 12 affleure à la surface 13 du dispositif selon une aire qui est représentée en coupe par ses limites A et B. Lorsqu'on désire établir un contact électrique avec la région 12, il importe, particulièrement lorsque ladite région 12 est à faible concentration d'impureté, de répartir ce contact sur la majeure partie de l'aire AB et de prévoir, en même temps, une élévation de la concentration d'impureté en surface de ladite région 12 de manière à rendre ohmique le contact. On applique donc, par sérigraphie à travers un écran approprié d'un type connu, un premier dépôt 15 d'une pâte conductrice qui contient, en plus des éléments habituels (solvant, liant organique, verre fusible, métal principal finement divisé choisi pour ses qualités électriques et de soudabilité), un élément de dopage qui est chargé, au cours d'un traitement thermique ultérieur, de migrer dans une pellicule superficielle 17 de la région 12 pour en enrichir la concentration d'impureté. Selon l'invention, après application et séchage au moins partiel, de ce premier dépôt 15, on effectue une application localisée d'un second dépôt 18 d'une pâte conductrice sérigraphiée, pâte qui, pour ce second dépôt, est essentiellement exempte d'élément de dopage. Le second dépôt 18 est situé en face d'une plage restreinte de l'aire AB. Il est réservé au contact, par soudure, avec la languette de connexion 19.

Dans le mode de mise en œuvre du procédé illustré par l'exemple de la fig. 1, le premier dépôt 15 de pâte conductrice est appliqué uniformément sur la majeure partie de l'aire AB alors que le second dépôt 18 est sérigraphié par-dessus le premier dépôt 15. Ce procédé permet de choisir une concentration d'élément de dopage dans le premier dépôt 15 qui soit suffisante pour que le contact entre ce dépôt et le semiconducteur de la région 12 ait de bonnes caractéristiques d'ohmicité et qui soit cependant assez modérée pour que la migration dudit élément de dopage dans le second dépôt 18 au cours du traitement thermique de vitrification, ne nuise pas à la soudabilité de la languette de connexion 19. La migration de l'élément de dopage de la portion 20 du premier dépôt 15 vers le dépôt 18 offre l'avantage que la concentration globale en élément de dopage reste faible dans l'ensemble du dépôt 18 et de la portion 20. On a donc dissocié, au sein de la configuration de contact constituée par l'ensemble des deux dépôts 15 et 18, la fonction de contact proprement dite avec le corps semiconducteur, et la fonction de liaison par soudage à une connexion métallique. Ceci est très favorable pour assurer à la soudure une tenue mécanique qui soit très résistante, même sous contrainte sévère d'environnement, et aussi pour obtenir une soudabilité de la connexion qui soit parfaite.

Dans les limites de la portion 20 du premier dépôt 15, le contact électrique avec le semiconducteur peut être déficient puisque la concentration en élément de dopage y est faible selon ce qui vient d'être expliqué. Ceci, conformément à l'invention, n'entraîne pratiquement pas de conséquence mesurable du fait que le second dépôt 18 a une superficie restreinte vis-à-vis de l'aire AB. Avantageusement, cette superficie est inférieure à 20% de ladite aire, et, de préférence, inférieure à 5% seulement. De plus, la forme géométrique elle-même du second dépôt 18 peut contribuer, dans la mesure où elle est faite étroite et allongée, à minimiser encore la résistance de conduction dans la portion du matériau semiconducteur de la région 12 qui est située à l'aplomb du second dépôt 18.

A titre d'exemple le corps semiconducteur 11 est en silicium, la région 12 est de type p avec une concentration d'impureté, sensiblement homogène, de l'ordre de $10^{16}$ atomes/cm$^3$. Le premier dépôt 15 est appliqué par sérigraphie d'une pâte à l'argent d'un type connu et disponible sur le marché, qui contient essentiellement: de la poudre d'argent en tant que métal principal, un matériau passif du type verre de scellement, généralement un borosilicate de zinc, un liant organique temporaire comme l'éthyl cellulose à propriétés thixotropiques convenables et un solvant comme le terpinéol, pâte à laquelle on a préalablement incorporé 0,8 à 2% en poids de poudre d'aluminium en tant qu'élément de dopage. L'écran de sérigraphie utilisé est en fil d'acier inoxydable de 60 micromètres de diamètre tissé en formant une maille de 100 micromètres de côté.

Le premier dépôt 15 est séché durant quelques minutes, à 150°C environ, pour éliminer le solvant contenu dans le dépôt. Après quoi, on applique, par sérigraphie localisée, le second dépôt 18 avec une pâte à l'argent semblable à la première, à la différence qu'on n'y incorpore pas de poudre d'aluminium. Le second dépôt est séché à son tour, par un traitement du dispositif à 150°C, puis le dispositif est porté à 400°C pour éliminer le liant organique de l'ensemble des dépôts. Enfin, une cuisson de vitrification intervient à une température de préférence comprise entre 600°C et 750°C, pendant 15 minutes environ, cuisson au cours de laquelle une partie de l'aluminium contenu dans le premier dépôt 15 interagit avec la surface du silicium et forme, après refroidissement, la pellicule 17 de silicium, riche en aluminium. La languette de connexion 19, en cuivre étamé par exemple, est très aisément soudée sur le second dépôt 18 à l'aide d'un alliage conventionnel de Pb-Sn.

Dans l'exemple d'application du procédé selon l'invention qui vient d'être décrit, on pourrait substituer à la pâte à l'argent, une pâte au cuivre. D'autre part, l'aluminium pourrait être remplacé, par exemple par du gallium, ou encore par du palladium.

On se reporte maintenant à la fig. 2 relative à une variante du procédé selon l'invention.

La région 22, du type p par exemple, affleure la surface 23 du corps 21 suivant l'aire AB représentée sur la figure en coupe. Dans ce mode de mise en œuvre particulier et avantageux de l'invention le premier dépôt 25 de pâte conductrice vitrifiable contenant l'addition d'un élément de dopage est appliqué sur la majeure partie de l'aire AB à l'exception d'un emplacement correspondant sensiblement à celui où sera pratiqué ultérieurement le soudage de la connexion 27; à cet emplacement, le dép*ot 25 présente un évidement 26. L'évidement 26 est obtenu en incorporant, de manière connue, un masque convenable à l'écran de sérigraphie. Le procédé se déroule ensuite de manière similaire à ce qui a été décrit à propos de l'exemple de la fig. 1, à la différence près que le second dépôt 28, de pâte conductrice, exempte d'élément de dopage, se trouve localisé de manière conjuguée avec l'évidement 26 pratiqué dans le premier dépôt 25. En effet, le second dépôt 28 s'étend à la fois dans l'évidement 26 où ledit second dépôt repose à la surface du semiconducteur de la région 22, et à la fois sur une zone 28b qui est contiguë audit évidement où ledit second dépôt 28 repose alors sur le premier dépôt 25. Selon cette variante du procédé, à l'emplacement de l'évidement 26, le dépôt sérigraphié ne contient pas d'élément de dopage, ce qui a l'avantage de permettre le soudage de la connexion 27 à cet emplacement dans d'excellentes conditions et d'assurer une robustesse optimale de la liaison soudée du fait qu'aucune perturbation physico-chimique causée par l'élément de dopage ne peut intervenir. La zone 28b sur laquelle les deux dépôts sérigraphiés se recouvrent assure la continuité électrique du contact entre la région 22 et la connexion 27. A l'emplacement de l'évidement 26, le contact entre le second dépôt 28 et le matériau de la région 22 est électriquement inactif.

L'inactivité d'une portion de la configuration de contact n'entraîne pas de conséquence nuisible, comme il a été déjà expliqué, du fait que, selon l'invention, le second dépôt 28 a une superficie très restreinte par rapport à l'aire AB sur laquelle la configuration de contact doit être créée. Un autre avantage de ce mode de mise en œuvre de l'invention est que la concentration en élément de dopage dans le premier dépôt 25 peut être augmentée à volonté sans risquer de retomber dans les difficultés de l'art antérieur. Par exemple, dans le cas de la pâte d'argent on peut utiliser jusqu'à 15% d'aluminium sans inconvénient.

Avantageusement, le second dépôt 28 est réalisé avec une épaisseur sensiblement supérieure à celle du premier dépôt 25, ce qui éloigne d'autant plus de la surface de la région 22, la soudure 30 de la connexion 27 et renforce la robustesse de la liaison mécanique sous l'effet des contraintes d'environnement sévères. Par exemple, si le premier dépôt 25 est réalisé avec une épaisseur typique de 10 micromètres, on s'efforce d'atteindre environ 20 micromètres pour l'épaisseur du second dépôt 28.

On se reporte maintenant à la fig. 3 pour décrire un exemple d'application du procédé selon l'invention à la prise de contact sur la face postérieure d'une cellule solaire au silicium. La cellule 40, de forme circulaire, a sa face photosensible du côté non visible sur la figure, tandis que la face 41, qui lui est opposée, comporte un dépôt conducteur de contact 42 sur l'essentiel de sa surface. En effet, ce dépôt est appliqué sur le matériau semiconducteur d'origine, c'est-à-dire faiblement concentré en impureté de dopage; aussi est-il habituel dans l'art, de répartir au maximum sur la face postérieure 41 le métal de contact de manière à réduire autant que possible la résistance interne de la cellule. Dans l'exemple décrit, le dépôt 42 est appliqué par sérigraphie d'une pâte conductrice contenant un élément de dopage de manière à permettre un contact ohmique de faible résistance sur le matériau semiconducteur d'origine. Selon l'invention un second dépôt de pâte conductrice est appliqué au moyen d'une opération supplémentaire de sérigraphie, opération qui est localisée aux deux plages 45a et 45b. Ce second dépôt, selon l'une des caractéristiques de l'invention, est effectué avec une pâte conductrice qui ne contient pas d'élément de dopage. La languette de connexion 47, en cuivre étamé, est ultérieurement soudée au centre des plages 45a et 45b à l'aide d'un alliage standard en plomb-étain.

Les opérations qui, par ailleurs, permettent d'obtenir la cellule avec ses caractéristiques propres habituelles, sont bien connues dans l'art.

La configuration de contact de la face antérieure photosensible peut être obtenue par exemple en ayant recours à la technique classique faisant appel à l'évaporation sous vide de titane et d'argent à travers un masque métallique, pour assurer la forme découpée habituelle du contact. Dans ce cas, il est avantageux de réaliser d'abord les dépôts de pâtes conductrices sur la face postérieure de la cellule, d'opérer les traitements thermiques de ces pâtes, y compris la cuisson de vitrification, à une température de l'ordre de 600° à 750°C, puis ensuite d'effectuer l'évaporation de Ti-Ag sur la face antérieure de la cellule suivie d'un recuit à environ 450°C. Ceci permet, en procédant dans cet ordre, d'éviter de faire subir à la métallisation de la face antérieure un traitement à une température inutilement élevée, traitement qui risquerait de détériorer les caractéristiques électriques de la région photosensible. On peut alors procéder au soudage des connexions électriques sur les deux faces de la cellule.

Le procédé selon l'invention, quoique particulièrement bien adapté à l'établissement d'un contact sur la face postérierue de cellules solaires, peut encore être appliqué à d'autres dispositifs semiconducteurs, notamment lorsqu'une région électrique de dimensions assez importantes doit être connectée vers un circuit extérieur alors que ladite région est faiblement concentrée en impureté à sa surface.

Bien entendu, l'invention n'est pas limitée aux exemples de réalisation ci-dessus décrits et représentés, à partir desquels on pourra prévoir d'autres modes et d'autres formes de réalisation sans pour cela sortir du cadre de l'invention.

**Revendications de brevet**

1. Procédé de création, sur une aire (AB) d'une surface d'un corps semiconducteur (11, 21), d'une configuration de contact apte au soudage d'une connexion métallique, ledit corps comportant une région (12, 22) d'un type de conductivité déterminé affleurant ladite surface suivant ladite aire, procédé consistant principalement à appliquer par sérigraphie au moins sur une partie de ladite aire, une pâte conductrice contenant notamment, dans une phase vitrifiable, au moins un métal principal finement divisé et un élément de dopage donnant ledit même type de conductivité, puis, ultérieurement, à vitrifier thermiquement ladite pâte dans des conditions telles que ledit dopant migre au moins dans une partie superficielle de ladite région, caractérisé en ce que, après avoir dans un premier dépôt (20, 25), appliqué ladite pâte conductrice contenant ledit élément de dopage et après avoir au moins partiellement séché ledit premier dépôt, on effectue face à au moins une plage restreinte de ladite aire qui contient l'emplacement destiné au soudage de ladite connexion, un second dépôt (18, 28) avec une pâte conductrice contenant notamment, dans une phase vitrifiable, au moins un métal principal et essentiellement dépourvue dudit élément de dopage, au moins une partie du second dépôt reposant sur une partie du premier dépôt, l'ensemble des deux dépôts constituant ladite configuration de contact, et en ce qu'on effectue ensuite le traitement de vitrification.

2. Procédé selon la revendication 1, caractérisé en ce que ladite plage en face de laquelle est localisé ledit second dépôt représente une superficie inférieure à 20% de ladite aire.

3. Procédé selon la revendication 2, caractérisé en ce que ladite plage représente une superficie qui est inférieure à 5% de ladite aire.

4. Procédé selon l'une quelconque des revendications 1 à 3, caractérisé en ce que ledit premier dépôt (20) étant appliqué sur l'essentiel de ladite aire, ledit second dépôt (18) est établi par-dessus ledit premier dépôt.

5. Procédé selon l'une quelconque des revendications 1 à 3, caractérisé en ce que ledit premier dépôt (25) étant appliqué sur ladite aire, on y ménage au moins un évidement (26) sur ledit emplacement de soudage, et en ce que ledit second dépôt (28), qui s'étend sur une partie (28b) du premier dépôt, est conformé de manière à s'étendre aussi sur la surface du corps (21) sur le lieu dudit évidement.

6. Procédé selon l'une quelconque des revendications 1 à 5, caractérisé en ce qu'on réalise ledit second dépôt (18, 28) avec une épaisseur sensiblement supérieure à celle dudit premier dépôt (20, 25).

7. Procédé selon l'une quelconque des revendications 1, 2, 3, 5 et 6 dans lequel ledit semiconducteur est du silicium, ledit métal principal l'argent et ledit élément de dopage l'aluminium, caractérisé en ce que la proportion d'aluminium dispersé dans ladite pâte conductrice dopée est comprise entre 0,8% et 15%.

8. Procédé selon la revendication 4, dans lequels ledit semiconducteur est du silicium, ledit métal principal l'argent et ledit élément de dopage l'aluminium, caractérisé en ce que la proportion d'aluminium dispersé dans ladite pâte conductrice dopée est comprise entre 0,8% et 2%.

9. Procédé selon l'une quelconque des revendications 1 à 8, caractérisé en ce que le traitement de vitrification desdits premier et second dépôts est effectué simultanément à une température comprise entre 600 et 750°C.

10. Dispositif semiconducteur (40), notamment pour la conversion photovoltaïque du rayonnement solaire, réalisé par le procédé selon l'une quelconque des revendications 1 à 9, caractérisé en ce que ladite région dudit corps est en silicium de type p, ledit métal principal est l'argent et ledit élément de dopage est l'aluminium.

### Patentansprüche

1. Verfahren, mit dessen Hilfe auf einem Gebiet (AB) einer Oberfläche eines Halbleiterkörpers (11, 21) eine Konfiguration von Kontakten erzeugt wird, die sich zum Schweissen einer metallischen Verbindung eignet, wobei der genannte Körper eine Zone (12, 22) von einem bestimmten Leitfähigkeitstyp enthält, das an die genannte Oberfläche entlang des genannten Gebietes grenzt, wobei dieses Verfahren im wesentlichen darin besteht, dass durch Siebdrucken wenigstens auf einem Teil des genannten Gebietes eine leitende Paste angebracht wird, die insbesondere in einer verglasbaren Phase mindestens ein feinverteiltes Hauptmetall und ein Dotierungselement enthält, das den gleichen genannten Leitfähigkeitstyp herbeiführt, und dass dann schliesslich thermisch die genannte Paste unter Bedingungen verglast wird, die derart sind, dass das genannte Dotierungselement wenigstens in einen Obeflächenteil der genannten Zone wandert, dadurch gekennzeichnet, dass, nachdem in einer ersten Schicht (20, 25) die genannte leitende Paste, die das genannte Dotierungselement enthält, angebracht und nachdem wenigstens teilweise die genannte erste Schicht getrocknet ist, wenigstens einem begrenzten Teil des genannten Gebietes gegenüber, der die für die Schweissung der genannten Verbindung bestimmte Stelle enthält, eine zweite Schicht (18, 28) mit einer leitenden Paste gebildet wird, die insbesondere in einer verglasbaren Phase mindestens ein Hauptmetall und mindestens einen im wesentlichen von dem genannten Dotierungselement freien Teil enthält, der auf einem Teil der ersten Schicht ruht, wobei die beiden Schichten die genannte Konfiguration von Kontakten bildet, und dass dann die Verglasungsbehandlung durchgeführt wird.

2. Verfahren nach Anspruch 1, dadurch gekennzeichnet, dass der genannte Teil des Gebietes, dem gegenüber sich die genannte zweite Schicht befindet, ein Oberflächengebiet von weniger als 20% des genannten Gebietes darstellt.

3. Verfahren nach Anspruch 2, dadurch gekennzeichnet, dass der genannte Teil des Gebietes ein Oberflächengebiet darstellt, das kleiner als 5% des genannten Gebietes ist.

4. Verfahren nach einem der Ansprüche 1 bis 3, dadurch gekennzeichnet, dass, wenn die genannte erste Schicht (20) auf dem grössten Teil des genannten Gebietes angebracht ist, die genannte zweite Schicht (18) über der genannten ersten Schicht angebracht wird.

5. Verfahren nach einem der Ansprüche 1 bis 3, dadurch gekennzeichnet, dass nach Anbringen der genannten ersten Schicht (25) auf dem genannten Gebiet in ihr mindestens eine Aussparung (26) an der genannten Schweissstelle vorgesehen wird, und dass die genannte zweite Schicht (28), die sich über einen Teil (28b) der ersten Schicht erstreckt, derart angebracht wird, dass sie sich auch auf der Oberfläche des Halbleiterkörpers (21) an der Stelle der genannten Aussparung erstreckt.

6. Verfahren nach einem der Ansprüche 1 bis 5, dadurch gekennzeichnet, dass die genannte zweite Schicht (18, 28) mit einer die der genannten ersten Schicht (20, 25) weit überschreitenden Dicke realisiert wird.

7. Verfahren nach einem der Ansprüche 1, 2, 3, 5 und 6, bei dem der genannte Halbleiterkörper aus Silicium, das Hauptmetall Silber und das genannte Dotierungselement Aluminium ist, dadurch gekennzeichnet, dass die in der genannten leitenden dotierten Paste dispergierte Aluminiummenge zwischen 0,8% und 15% liegt.

8. Verfahren nach Anspruch 4, bei dem der genannte Halbleiterkörper aus Silicum, das genannte Hauptmetall Silber und das genannte Dotierungselement Aluminium ist, dadurch gekennzeichnet, dass die in der genannten leitenden dotierten Paste dispergierte Aluminiummenge zwischen 0,8% und 2% liegt.

9. Verfahren nach einem der Ansprüche 1 bis 8, dadurch gekennzeichnet, dass die Behandlung zur Verglasung der genannten ersten und der genannten zweiten Schicht gleichzeitig bei einer Temperatur zwischen 600 und 750°C durchgeführt wird.

10. Halbleiteranordnung (40), insbesondere zur Umwandlung von Sonnenstrahlung in eine Photospannung, die durch das Verfahren nach einem der Ansprüche 1 bis 9 hergestellt ist, dadurch gekennzeichnet, dass die genannte Zone des genannten Halbleiterkörpers aus P-leitendem Silicium besteht, das genannte Hauptmetall Silber und das genannte Dotierungselement Aluminium ist.

## Claims

1. A method of forming a contact configuration for soldering a metal connection on a region (AB) of a surface of a semiconductor body (11, 21), the said body comprising a zone (12, 22) of a given conductivity type which adjoins the said surface according to the said region, said method mainly comprising the provision by serigraphy on at least a part of the said region of a conductive paste which, in particular in a vitrifiable phase, comprises at least a principal metal which is finely divided and a doping element which gives the same conductivity type, the said paste is then vitrified thermally in such circumstances that the said dopant migrates into at least a surface part of the said region, characterized in that after providing the conductive paste with the doping element in a first deposit (20, 25) and after at least partly drying the said first deposit, a second deposit (18, 28) with a conductive paste containing notably, in a vitrifiable phase, at least a principal metal and being substantially free from said doping element is provided opposite at least a restricted part of the said region comprising the location where the said connection is to be soldered, at least a part of the second deposit bearing on a part of the first deposit, the assembly of the two deposits forming the said contact configuration, and in that the vitrification is then carried out.

2. A method as claimed in Claim 1, characterized in that the said surface opposite which the said second deposit is located has an area which is smaller than 20% of the said region.

3. A method as claimed in Claim 2, chracterized in that the said surface has an area which is smaller than 5% of the said region.

4. A method as claimed in any of the Claims 1 to 3, characterized in that the said first deposit (20) is provided on the major part of the said region and the said second deposit (18) is provided on the said first deposit.

5. A method as claimed in any of the Claims 1 to 3, characterized in that the said first deposit (25) is provided on the said region, at least a recess (26) is provided in the said soldering place and in that, the said second deposit (28) which extends over a part (28b) of the first deposit is realized in such manner as to extend also on the surface of the body (21) at the location of the said recess.

6. A method as claimed in any of the Claims 1 to 5, characterized in that the said second deposit (18, 28) is provided with a thickness which is considerably larger than that of the said first deposit (20, 25).

7. A method as claimed in any of the Claims 1, 2, 3, 5 and 6, in which the said semiconductor is silicon, the said principal metal is silver and the said doping element is aluminium, characterized in that the ratio of aluminium dispersed in the said doped conductive paste is between 0.8% and 15%.

8. A method as claimed in Claim 4, in which the said semiconductor is silicon, the said principal metal is silver and the said doping element is aluminium, characterized in that the ratio of aluminium dispersed in the said doped conductive paste is between 0.8% and 2%.

9. A method as claimed in any of the Claims 1 to 8, characterized in that the vitrification of the said first and second deposits is carried out simultaneously at a temperature between 600 and 750 °C.

10. A semiconductor device (40) especially for the photovoltaic conversion of solar radiation manufactured by a method as claimed in any of the Claims 1 to 9, characterized in that the said zone of the said body is silicon of the p-type, the said principal metal is silver and the said doping element is aluminium.

FIG.1

FIG.2

FIG.3